# FASCICULE DE BREVET EUROPEEN

(11) **EP 0 545 808 B1**
(45) Date de publication et mention de la délivrance du brevet: **22.03.1995**
(21) Numéro de dépôt: 92403237.8
(22) Date de dépôt: 01.12.1992
(51) Int. Cl.: H01S 3/19, H01L 33/00, G02F 1/00

(54) **Dispositif optoélectronique à très faible résistance série**
Optoelektronische Vorrichtung mit sehr niedrigem Serienwiderstand
Optoelectronic device with very low series resistance

(30) Priorité: 04.12.1991 FR 9115000
(43) Date de publication de la demande: 09.06.1993
(73) Titulaire: FRANCE TELECOM, 75015 Paris (FR)
(72) Inventeur: Kazmierski, Christophe, F-91420 Morangis (FR); Rose, Benoît, F-75018 Paris (FR)
(74) Mandataire: Dubois-Chabert, Guy

(56) Documents cités:
- EP-A- 0 380 322
- US-A- 4 371 967
- IEEE JOURNAL OF QUANTUM ELECTRONICS, vol. 27, no. 6, Juin 1991, New York,US;pages 1794 - 1797 C.KAZMIERSKI et al.:"High static performance GaInAs-GaInAsP SCH MQW 1.5 mum wavelength buried ridge stripe lasers"
- PATENT ABSTRACTS OF JAPAN vol. 13, no. 181 (E-750)27 Avril 1989;& JP-A-1007667
- PATENT ABSTRACTS OF JAPAN vol. 11, no. 73 (E-486)5 Mars 1987;& JP-A-61228684
- JAPANESE JOURNAL OF APPLIED PHYSICS, vol. 25, no. 8, Août 1986, Tokyo,JP;pages 1169 - 1173 K.KASIMIERSKI et al.:"A simple model and calculation of the influence of doping and intrinsic concentrations on the interstitial-substitutional diffusion mechanism: Application to Zn and Cd in InP"

## Description

L'invention a pour objet un dispositif optoélectronique à semi-conducteur et à très faible résistance série. Elle s'applique dans le domaine des lasers, des modulateurs et autres dispositifs semi-conducteurs à double hétérostructure pour la transmission d'informations, guidée ou non par fibre optique.

Plus spécialement, ses applications sont celles des lasers de grande puissance et à rendement élevé utilisables en particulier dans le domaine de la photochimie, des télécommunications, de la télévision, de l'informatique et de la télémétrie.

Ce dispositif utilise comme matériau semi-conducteur des composés à base d'éléments III et V de la classification périodique des éléments.

Une double hétérostructure est constituée d'une couche de semi-conducteur à faible bande d'énergie interdite, dite couche active, entourée de chaque côté de couches semi-conductrices à bande d'énergie interdite plus large qui jouent le double rôle de confinements optique et électrique.

Les exemples typiques de doubles hétérostructures sont une couche de GaAs entre deux couches d'alliage GaₐAl₁₋ₐAs avec 0<a≦1 pour l'émission à 0,8»m et une couche d'alliage Ga_{b}In_{1-b}As_{c}P_{1-c} avec 0≦b≦1 et 0≦c≦1 entre deux couches d'InP pour l'émission à 1,3 »m ou à 1,5 »m.

Ces couches en matériau semi-conducteur sont déposées sur des substrats en GaAs ou InP par une des méthodes de croissance suivantes : épitaxie en phase liquide, en phase gazeuse, par jet moléculaire ou chimique.

La couche active a la forme géométrique d'un ruban qui guide l'émission de lumière avec une contre-réaction optique due aux réflexions sur des miroirs constitués par les faces perpendiculaires au ruban, clivées ou gravées, ou bien par des réseaux périodiques introduisant une perturbation d'indice dans le ruban laser.

Deux métallisations disposées de part et d'autre de l'empilement de couches semi-conductrices complètent la structure laser.

Potentiellement, les dispositifs lasers à semi-conducteur peuvent être très puissants et répondre très rapidement aux perturbations électriques, leurs performances étant souvent limitées par la résistance série liée à la structure du dispositif. Par conséquent, la résistance série provoque une augmentation des pertes calorifiques et la diminution des performances statiques du dispositif comme le courant de seuil, le rendement quantique de conversion électron-photon, la puissance optique et, dans le cas des lasers, le rendement énergétique. De plus, les performances dynamiques dépendent de la résistance série par l'intermédiaire du produit RC du dispositif, ce qui limite la bande passante.

Avec les progrès des télécommunications, de la télévision et de l'informatique, le volume d'informations échangées et les distances de transmission croissent très rapidement. Une des solutions pour assurer la transmission et la distribution de l'information est la communication optique par fibres (voie terrestre) ou par satellite (voie spatiale) qui fait appel à l'utilisation de lasers très puissants et/ou très rapides.

Les solutions généralement adoptées vont dans le sens d'une optimisation du comportement optique du composant, ce qui impose de doper le matériau semi-conducteur et introduit donc une résistance série.

En général, la couche active est non intentionnellement dopée. En outre, l'une des couches de confinement est dopée n et l'autre couche de confinement est dopée p afin de réaliser une jonction p-n.

La résistance série d'un dispositif électronique à double hétérostructure avec une jonction p-n comme dans le laser BRS (Buried Ridge Stripe publié par exemple dans l'article de Bouley J.C. et al. dans Proceedings of the 9th IEEE International Semiconductor Laser Conference, "1.55»m strip buried Schottky laser", page 54, Août 1984), est limitée essentiellement par la résistance série entre les électrodes de métallisation et leur interface avec le semi-conducteur et par la conductivité des couches semi-conductrices elles-mêmes.

De grands efforts ont été et sont toujours déployés pour diminuer la résistance électrique des métallisations. Cette résistance étant devenue actuellement comparable à celle des couches semi-conductrices, il serait efficace d'agir aussi sur la résistance des couches semi-conductrices.

Une façon évidente est d'augmenter le niveau de dopage, plus spécialement du côté p de la jonction p-n, le matériau p étant plus résistif du fait que la mobilité des trous est jusqu'à 100 fois plus faible que celle des électrons. Mais, il a été démontré, par exemple par Sasaki et al. (Journal of Crystal Growth 93(1988), pages 838-842, "Doping optimization in InGaAsP DH Lasers and improved characteristics in BH lasers grown by MOVPE"), qu'une augmentation de dopage p au-delà de 5x10¹⁷ ions/cm³ conduit à une forte dégradation des caractéristiques des dispositifs lasers. Cette perte de performances a été attribuée à la diffusion du dopant p (ici Zn) dans la couche active.

Peu de travaux ont été publiés à ce jour concernant la possibilité d'employer un dopage p très élevé probablement parce que le phénomène de diffusion des accepteurs pendant la croissance de la couche active étant d'environ 200nm, un contrôle de la diffusion à 20nm près serait nécessaire.

Néanmoins, quelques efforts pour éviter la diffusion du zinc dans la couche active laser sont à noter.

Le brevet US-A-437197 décrit un laser à semi-conducteur comportant une couche d'arrêt de diffusion dopée, interposée entre l'une des couches de confinement et la couche active.

Y.L. Wang et al. a publié dans Applied Physics Letters 57 (Octobre, 1990), page 1864, "Buried-heterostructure lasers fabricated by in situ processing techniques", une structure laser réalisée par la méthode d'épitaxie par jets moléculaires, comportant une couche additionnelle d'InP non-intentionnellement dopé (type n), intercalée entre la couche active en InGaAsP non intentionnellement dopé et la couche de confinement en InP dopé p.

Le rôle de cette couche additionnelle est d'espacer ("spacer" en terminologie anglo-saxonne) la couche active exactement de la distance de diffusion du zinc pendant le dépôt de la couche p.

Une étude de diffusion du zinc dans les conditions de croissance épitaxiale a été nécéssaire pour déterminer précisément l'épaisseur de la couche supplémentaire ("spacer").

La même idée d'une couche InP séparatrice est aussi reportée par Sasaki dans l'article cité précédemment.

Habituellement, des structures lasers aux performances optoélectroniques optimisées ont une résistance série entre 4 et 10 ohms pour une structure de 300»m environ de long, comme par exemple celle d'un laser BRS décrit par P. Devoldere et al. dans IEE Proceedings J, vol.136, n°1 (1989), pages 76-82, "Lasers on semi-insulating InP substrate".

Actuellement, la couche séparatrice en InP non intentionnellement dopé semble être le seul moyen utilisé dans des structures de dispositifs optoélectroniques pour empêcher la dégradation de la couche active par diffusion d'accepteurs d'une couche à faible résistivité (c'est-à-dire fortement dopée) qui se trouve amplifiée à la température de croissance épitaxiale. Cependant, cette technique n'élimine pas le problème du contrôle de la position de la jonction p-n, car il y a toujours diffusion chimique de l'accepteur dans la couche séparatrice.

Un autre inconvénient pratique est la nécessité d'étalonner l'épaisseur de la couche séparatrice à chaque fois que l'on change la méthode ou les conditions de croissance, le matériau semi-conducteur ou la structure. Ces inconvénients rendent difficiles l'utilisation des dopages très élevés nécessaires à l'obtention d'une résistance série faible.

Le but de l'invention est de proposer une structure de dispositif optoélectronique avec un empilement modifié de couches semi-conductrices permettant de remédier aux inconvénients ci-dessus. Ce dispositif présente notamment une faible résistance série sans dégradation du courant de seuil et du rendement quantique de conversion électron-photon.

La structure semi-conductrice proposée a l'avantage d'un meilleur contrôle de la position de la jonction p-n, indépendamment de la méthode et des conditions d'épitaxie, et permet, par rapport à l'art antérieur, de maîtriser des dopages plus élevés.

De façon plus précise, l'invention a pour objet un dispositif optoélectronique comportant un substrat III-V, une couche inférieure semi-conductrice de confinement en matériau III-V dopé n, disposée au contact du substrat, une zone active comportant au moins une couche active semi-conductrice en matériau III-V non intentionnellement dopé, disposée sur la couche inférieure de confinement, une couche supérieure semi-conductrice de confinement en matériau III-V dopé p, recouvrant la zone active, la bande d'énergie interdite de la couche active étant inférieure à celle des couches de confinement, une première métallisation disposée au-dessus de la couche supérieure de confinement, une seconde métallisation disposée sur le substrat, une couche semi-conductrice d'arrêt de diffusion des ions dopants de la couche supérieure de confinement disposée entre la couche active et la couche supérieure de confinement, ce dispositif étant caractérisé en ce que la couche d'arrêt est réalisée en matériau III-V quaternaire fortement dopé n, et en ce que cette couche d'arrêt présente une épaisseur inférieure ou égale à celle de la couche active et fait aussi partie de la zone active. Par fortement dopé, il faut comprendre un dopage supérieur à 10¹⁷ ions cm³.

L'invention s'applique à tout type de matériau III-V. En particulier l'élément III est choisi parmi l'aluminium, le gallium et l'indium et l'élément V est choisi parmi le phosphore, l'arsenic ou l'antimoine. En outre, les couches semi-conductrices peuvent être en matériau binaire, ternaire ou quaternaire. En particulier, le substrat est en GaAs ou InP.

La couche active peut être réalisée en un seul matériau ou être composée d'un empilement de couches formant une structure active dite à "puits quantiques", c'est-à-dire une structure comportant des couches alternées minces de deux types de matériaux, l'un ayant une bande d'énergie interdite inférieure à l'autre.

De part et d'autre de cette couche active, il est possible d'utiliser une couche de composition graduelle dont la surface au contact de la couche active a la même composition que celle-ci et dont la surface au contact de la couche supérieure de confinement a la même composition que cette dernière.

Si nécessaire, il est possible d'utiliser une couche de protection de la zone active, disposée entre la couche supérieure de confinement et la première métallisation,

La couche quaternaire d'arrêt peut avoir une composition identique ou différente de celle des couches composant la couche active.

Selon un mode de réalisation, elle aura une composition identique à celle de l'une des couches composant la couche active.

Pour un substrat en GaAs, la couche d'arrêt peut être Ga_{1-d}Al_{d}As₁₋ₑPₑ avec 0≦d<1 et 0≦e<1.

Cependant, le dispositif de l'invention est particulièrement bien adapté aux lasers de type BRS dans lesquels le substrat est en InP.

Sur un tel substrat, on utilise avantageusement une couche inférieure de confinement en InP dopé n, une couche active en Ga₁₋ₓInₓAs_{1-y}P_{y} avec 0≦x≦1 et 0≦y≦1, non intentionellement dopé, une couche inférieure de confinement en InP dopé p+ et une couche d'arrêt de diffusion en Ga_{1-z}In_{z}As₁₋ₜPₜ avec 0<z<1 et 0<t<1, dopé n.

Bien entendu, x, y, z et t sont choisis pour que la couche active ait une bande d'énergie interdite inférieure à celle des couches de confinement.

Dans ce type de structure, le dopage p élevé dans la jonction InP-n/InP-p des deux côtés de la zone active agit dans le sens de la diminution des courants de fuite latérale et, par là même, dans le sens de l'amélioration du confinement du courant laser dans la couche active.

De façon avantageuse, la couche quaternaire est dopée à une concentration en ions donneurs égale ou supérieure à celle des ions accepteurs de la couche supérieure de confinement, et en particulier, a une concentration en ions dopants donneurs de 5.10¹⁷ à 5.10¹⁸ions/cm³.

D'autres caractéristiques et avantages de l'invention ressortiront mieux de la description qui va suivre, donnée à titre illustratif et non limitatif, en référence aux figures annexées sur lesquelles :
- la figure 1 montre, schématiquement, en coupe transversale, une structure laser conforme à l'invention,
- la figure 2 est une courbe donnant les variations de la densité de courant, exprimé en ampères/cm² en fonction de la tension exprimée en volt appliquée à des diodes à hétérojonction avec ou sans couche supplémentaire quaternaire,
- les figures 3a à 3c représentent schématiquement les différentes étapes de fabrication d'une structure laser conforme à l'invention.

Dans la description qui suit, les exemples donnés correspondent à une structure utilisant largement le semi-conducteur InP, mais il va de soi que l'invention n'est pas limitée à ce cas.

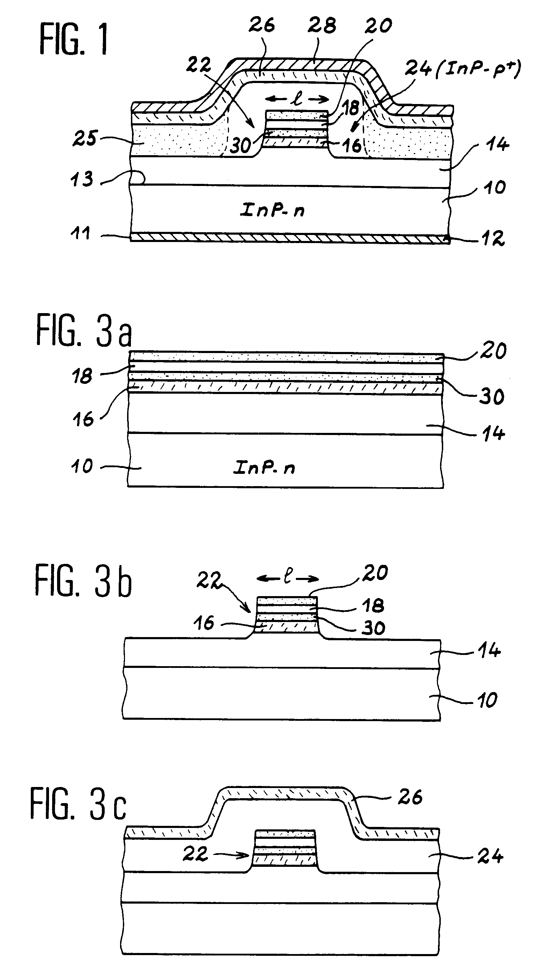

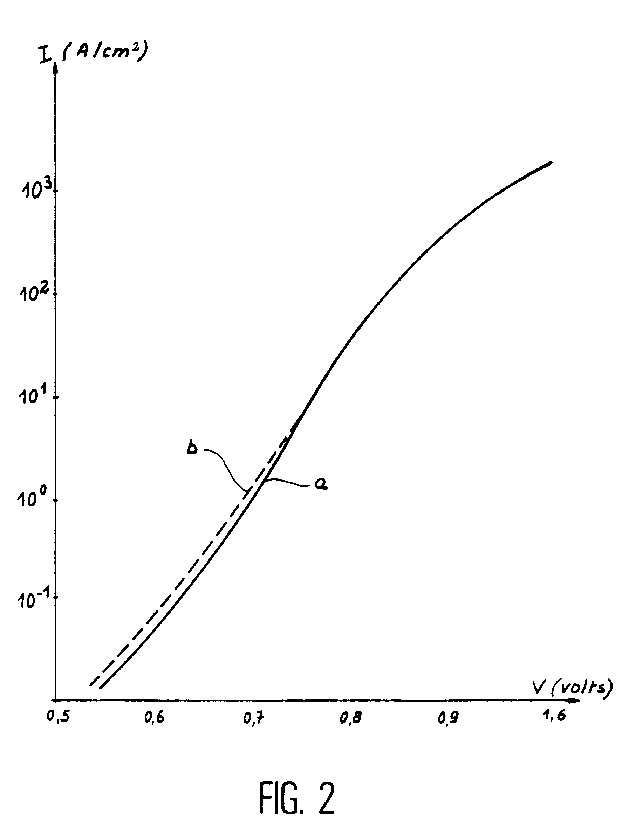

La figure 1 montre en coupe transversale, une structure laser selon l'invention de type BRS. On y retrouve un empilement de couches similaires à celui rencontré dans les structures lasers connues.

Cette structure comporte un substrat 10 d'InP de type n (dopé silicium) avec une concentration en ions dopants de 5.10¹⁸ ions/cm³ environ, une métallisation 12 en AuTi sur sa face inférieure 11 et une couche de confinement inférieure ou couche tampon 14 sur sa face supérieure 13. La couche tampon 14 est en InP dopé n à une concentration de 5x10¹⁷ à 3x10¹⁸ions silicium/cm³. Elle présente une épaisseur de 0,5 à 2,0»m.

Cette couche tampon 14 supporte une couche active 16. Cette couche 16 est par exemple en matériau quaternaire Ga₁₋ₓInₓAs_{1-y}P_{y} massif avec 0<x<1 et 0<y<1 non intentionnellement dopé. Le dopage résiduel est de type n avec une concentration de l'ordre de 10¹⁶ ions/cm³. L'épaisseur de la couche est de 15nm environ.

La composition de la couche active 16 peut être ajustée en fonction de la longueur d'onde d'émission choisie et notamment pour que le laser émette dans la fenêtre de 1,5»m ou 1,3»m.

L'émission à 1,5»m correspond à x de l'ordre de 0,6 et y de l'ordre de 0,1 et une émission à 1,3»m correspond à x de l'ordre de 0,75 et à y de l'ordre de 0,5.

Il est aussi possible de réaliser la couche active 16 sous forme d'une structure dite à "puits quantiques" constituée d'un empilement de couches de Ga₁₋ᵤInᵤAs/Ga₁₋ₓInₓAs_{1-y}P_{y} non intentionnellement dopé (type n résiduel), avec 0≦u≦1 et x et y des valeurs données ci-dessus. Les couches en GaInAs constituent les puits quantiques. Les couches en GaInAsP jouent le rôle de guide optique et peuvent avoir une composition constante ou graduelle ; les couches servant de guide optique présentent une largeur de bande interdite supérieure à celle des couches jouant le rôle de puits quantiques. Ces structures à puits quantiques sont aussi connues sous le nom de structure à réseau.

En particulier, on peut utiliser une structure à 3 puits quantiques de 7nm d'épaisseur et de composition u en indium de 0,53 et à 4 guides optiques de composition constante en indium et phosphore avec x valant 0,75 et y valant 0,5 et de 10nm d'épaisseur.

De façon connue, la structure laser peut éventuellement comporter une ou plusieurs couches 18 au contact de la couche active réalisée en Ga₁₋ᵥInᵥAs_{1-w}P_{w} avec 0≦v≦1 et 0≦w≦1, non intentionnellement dopé (type n résiduel) et de largeur de bande interdite supérieure à celle de la couche active 16 lorsque celle-ci est en GaInAsP massif, ces couches alternant avec des couches en InP non intentionnellement dopé ; cette structure constitue un réseau de Bragg périodique de miroirs distribués.

Un laser équipé de ce réseau de Bragg est connu sous le nom de laser DFB.

L'empilement 18 a une épaisseur de 140nm environ. Il peut par exemple consister en une couche de GaInAsP de 20 nm d'épaisseur avec des compositions v en In et w en P valant respectivement 0,75 et 0,5 et en deux couches d'InP de 60nm d'épaisseur.

Ce réseau de Bragg 18 supporte éventuellement une couche 20 de protection de la zone active, réalisée en InP de type p avec une épaisseur de 0,01»m à 0,2»m et une concentration en ions dopants (zinc) de 5.10¹⁷ ions/cm³.

La couche active 16, la couche 18 à réseau de Bragg et la couche 20 de protection sont gravées pour former un ruban 22 de largeur l allant de 1 à 3»m constituant la zone active du laser.

Le ruban actif 22 est recouvert d'une couche 24 en InP de type p (dopage au zinc) constituant la couche supérieure de confinement.

En vue du confinement latéral de la lumière, la couche 24 de confinement comporte de part et d'autre de la zone active 22 des zones 25 obtenues par implantation de protons.

On trouve ensuite une couche de contact 26 en Ga_{1-f}In_{f}As avec 0≦f≦1 de type p+ et une métallisation 28 supportée par la couche de contact 26. La métallisation 28 est un alliage de TiPt rechargé en or et a une épaisseur de 150nm. La couche de contact a par exemple une composition f en indium valant 0,53, une épaisseur de 200nm et une concentration en dopant p de 5x10¹⁸ions/cm³ à 2x10¹⁹ions/cm³, typiquement de 1x10¹⁹ions/cm³.

Selon une réalisation de l'invention, la structure laser représentée sur la figure 1 se distingue de celles de l'art antérieur par une couche supplémentaire 30 en matériau quaternaire dopé n entre 5x10¹⁷ ions/cm³ et 5x10¹⁸ ions/cm³ par exemple en Ga_{1-z}In_{z}As₁₋ₜPₜ avec 0<z<1 et 0<t<1 servant de couche d'arrêt de diffusion des ions dopants p (ici zinc) de la couche de confinement supérieure 24. Cette couche 30 sert à protéger la couche active 16.

Cette couche 30 a par exemple la même composition que la couche active 16 (soit z et t valant respectivement 0,6 et 0,1 pour une émission à 1,5»m et z et t valant respectivement 0,75 et 0,5 pour une émission à 1,3»m) et fait aussi partie de la zone active 22 du laser. Dans ces conditions, la couche 30 se présente aussi sous la forme d'un ruban de largeur l. De plus, l'épaisseur de cette couche supplémentaire 30 est inférieure ou égale à celle de la couche active 16. Typiquement, elle présente une épaisseur de 15nm.

Par ailleurs, selon l'invention, la couche 24 de confinement supérieure est dopée de type p à un dopage supérieur à 1x10¹⁸ ions/cm³ et par exemple compris entre 1x10¹⁸ ions/cm³ et 1x10¹⁹ ions/cm³. Ce dopage est typiquement de 2x10¹⁸ ions/cm³. En outre, cette couche 24 a une épaisseur de 1500nm.

Une évaluation de la résistance série de la structure BRS selon l'invention conduit à une valeur de la résistance série inférieure à 2 ohms pour une longueur L de dispositif, mesurée selon une direction perpendiculaire à l, de 250»m, soit 2 à 5 fois moins que celle des structures lasers optimisées.

Les performances statistiques et dynamiques du dispositif de l'invention sont conservées, voire améliorées par rapport à celles de l'art antérieur.

Le demandeur a effectué divers essais et études pour vérifier les faits essentiels de l'invention sur le fonctionnement de la structure laser, c'est-à-dire celui du blocage de la diffusion des ions zinc par une couche d'arrêt en Ga_{1-z}In_{z}As₁₋ₜPₜ dopé n, entre le Ga₁₋ₓInₓAs_{1-y}P_{y} de la couche active et l'InP de type p de la couche^{y}de confinement supérieure 24.

Le mécanisme de la diffusion est décrit par le demandeur dans le document Japanese Journal of Applied Physics, vol. 25, n°8, août 1986, pp. 1169-1173, de K. Kazmierski et B. de Cremoux, "A simple model and calculation of the influence of doping and intrinsic concentrations on the interstitial-substitutional diffusion mechanism : Application to Zn and Cd in InP".

La diffusion d'accepteurs s'accélère en présence de trous (matériau de type p) ou se ralentit en présence d'électrons (matériau de type n), un arrêt total de la diffusion se faisant si la concentration de dopant n dépasse celle des accepteurs p. De plus, cette diffusion se ralentit dans les matériaux GaInAsP de composition variant de l'InP vers le GaInAs.

Les deux phénomènes agissant conjointement, il est permis d'ajuster l'épaisseur de la couche bloquante 30 à de très faibles valeurs, par exemple inférieures à 20nm et typiquement de 5 à 15nm.

Un autre point important de l'invention concerne la fuite du courant par la jonction parasite p-n en InP du fait du fort dopage p de la couche 24 et de la structure BRS.

Le courant de fuite dépend de l'écart de tension de polarisation directe que l'on applique sur les électrodes pour un courant donné entre la jonction active et l'homojonction. Une augmentation de la tension en direct pour une diode active plus complexe pourrait éliminer cet écart.

Le demandeur a vérifié que la tension de polarisation directe d'une diode active selon l'invention avec la couche quaternaire supplémentaire, fortement dopée n, n'augmente pas par rapport au cas où cette couche est absente. Les résultats sont portés sur la figure 2.

Sur cette figure 2, on donne les caractéristiques courant-tension de deux diodes à hétérojonction avec et sans couche supplémentaire quaternaire. Ces diodes comportent une couche de confinement supérieure dopée à 2x10¹⁸ ions/cm³ de type p, une couche de confinement inférieure en InP dopé à 1x10¹⁸ ions/cm³ avec un dopant n et une couche active en Ga₁₋ₓInₓAs_{1-y}P_{y} non intentionnellement dopé avec x valant 0,75 et y valant 0,50.

Les courbes a et b donnent respectivement les variations de la densité de courant I, exprimée A/cm², en fonction de la tension V exprimée en Volt pour une diode comportant une couche quaternaire supplémentaire de Ga_{1-z}In_{z}As₁₋ₜPₜ avec z valant 0,75 et t valant 0,50, dopé n+ à 1.10¹⁸ ions/cm³, entre la couche active et la couche d'InP dopé p, et pour une diode dépourvue de cette couche supplémentaire.

La structure laser de l'invention est conçue pour être réalisée en deux étapes d'épitaxie. Le procédé de fabrication de la structure laser de la figure 1 est représenté sur les figures 3a à 3c.

Dans un premier cycle d'épitaxie et en référence à la figure 3a, on dépose selon la technique de dépôt chimique en phase vapeur, avec des organométalliques (MOVPE) sur le substrat 10 en InP de type n, les couches suivantes :
- la couche tampon 14 d'InP de type n ;
- la couche 16 par exemple de Ga₁₋ₓInₓAs_{1-y}P_{y}, non intentionnellement dopé, avec x et y tels que donnés précédemment pour émettre dans la fenêtre de 1,3»m ou 1,5»m ;
- la couche 30 d'arrêt de diffusion en Ga_{1-z}In_{z}As₁₋ₜPₜ de même composition que la couche 16, dopé n à 1x10¹⁸ ions silicium/cm³ ;
- la couche 18 en réseau de Bragg ; puis,
- la couche de protection 20 en InP de type P.

On effectue alors, comme représenté sur la figure 3b une gravure des couches 16, 18, 30 et 20 pour obtenir le ruban actif 22 de largeur 1. Cette gravure s'effectue selon des directions cristallographiques préférentielles, par exemple selon la direction <110> ou <11̅0>.

Ces gravures sont effectuées par voie chimique en utilisant comme agent d'attaque HBr:Br.

Il est toutefois possible de faire ces gravures par voie sèche selon la technique de gravure ionique réactive ou selon l'usinage ionique, bien connu de l'homme de l'art.

On procède alors, comme représenté sur la figure 3c, à un deuxième cycle d'épitaxie MOVPE pour faire croître les couches 24 d'InP dopé p+ et la couche 26 de contact en Ga_{1-f}In_{f}As dopé p+.

L'électrode supérieure 28 est alors réalisée sur la couche 26 en utilisant un dépôt de métallisation TiPt rechargé en or. L'électrode inférieure 12 en TiAu est déposée sur la face 11 du substrat d'InP. On effectue alors une implantation ionique de protons 25 de part et d'autre du ruban laser 22, rendant semi-isolant dans ces régions 25 la couche 24 en InP de type p, afin d'assurer une isolation électrique du ruban laser, du reste de la structure.

On effectue alors un clivage de la structure, selon une direction perpendiculaire au ruban laser 22, pour réaliser les deux miroirs semi-réfléchissants.

Une résistance série de 1,5 ohm a été obtenue avec cette réalisation présentant un courant de seuil de 15mA et une puissance optique maximale supérieure à 40mW (maximum 90 mW) par face pour une longueur de dispositif de 250»m.

Ces excellentes caractéristiques statiques prouvent l'efficacité du dopage élevé et du blocage de la diffusion des dopants p dans la couche active dans la structure de l'invention.

Le produit RC de cette réalisation (c'est-à-dire laser BRS d'une longueur de 250»m avec des miroirs non traités) a été mesuré en utilisant un analyseur de réseau électrique. D'après l'analyse du diagramme de Smith correspondant, un schéma équivalent RC de la structure a été déduit. La valeur RC de la structure de l'invention (soit 1,5ohmsx5pF), en basse et en haute fréquence, est plus faible que 8 ps, ce qui correspond à une limite de bande passante meilleure que 20 GHz.

Les bandes passantes effectivement mesurées sur ces composants dépassent 16 GHz avec un maximum supérieur à 18 GHz; elles sont plus élevées que celles des dispositifs lasers BRS de l'art antérieur.

## Revendications

1. Dispositif optoélectronique comportant un substrat III-V (10), une couche inférieure semi-conductrice de confinement (14) en matériau III-V dopé n, disposée au contact du substrat (10), une zone active (22) comportant au moins une couche active semi-conductrice (16) en matériau III-V non intentionnellement dopé, disposée sur la couche inférieure de confinement (14), une couche supérieure semi-conductrice de confinement (24) en matériau III-V dopé p, recouvrant la zone active, la bande d'énergie interdite de la couche active étant inférieure à celle des couches de confinement, une première métallisation (12) disposée au-dessus de la couche supérieure de confinement, une seconde métallisation (28) disposée sur le substrat, et une couche semi-conductrice (30) d'arrêt de diffusion des ions dopants de la couche supérieure de confinement disposé entre la couche active et la couche supérieure de confinement, ce dispositif étant caractérisé en ce que la couche d'arrêt (30) est réalisée en matériau III-V quaternaire dont le dopage de type n est supérieur à 10¹⁷ ions/cm³ et en ce que cette couche d'arrêt (30) présente une épaisseur inférieure ou égale à celle de la couche active et fait aussi partie de la zone active.

2. Dispositif selon la revendication 1, caractérisé en ce que la couche quaternaire (30) est dopée à une concentration en ions donneurs égale ou supérieure à celle des ions accepteurs de la couche supérieure de confinement.

3. Dispositif selon la revendication 1 ou 2, caractérisé en ce que la couche quaternaire est dopée avec une concentration en ions dopants donneurs de 5x10¹⁷ à 5x10¹⁸ions/cm³.

4. Dispositif selon l'une quelconque des revendications 1 à 3, caractérisé en ce que la couche quaternaire (30) a une composition identique à une des couches composant la couche active.

5. Dispositif selon l'une quelconque des revendications 1 à 4, caractérisé en ce que la couche supérieure de confinement (24) est dopée à au moins 10¹⁸ ions dopants accepteurs/cm³.

6. Dispositif selon l'une quelconque des revendications 1 à 5, caractérisé en ce qu'une couche de protection (20) de la zone active est prévue entre la couche supérieure de confinement et la première métallisation.

7. Dispositif selon l'une quelconque des revendications 1 à 6, caractérisé en ce que le substrat est en InP, la couche inférieure (14) de confinement est en InP dopé n, la couche active (16) est en Ga₁₋ₓInₓAs_{1-y}P_{y} avec 0≦x≦1 et 0≦y≦1, non intentionnellement dopé, la couche supérieure (24) de confinement est en InP dopé p+ et la couche d'arrêt de diffusion (30) est en Ga_{1-z}In_{z}As₁₋ₜPₜ avec 0<z<1 et 0<t<1, dopé n à une concentration de 5x10¹⁷ à 5x10¹⁸ ions/cm³.

8. Dispositif selon l'une quelconque des revendications 1 à 7, caractérisé en ce que la zone active (22) présente la forme d'un ruban entouré par la couche supérieure (24) de confinement.

## Patentansprüche

1. Optoelektronische Vorrichtung, umfassend ein III-V-Substrat (10), eine untere Halbleiter-Grenzschicht (14) aus n-dotiertem III-V-Material, angeordnet mit Kontakt zum Substrat (10), eine aktive Zone (22), wenigstens eine aktive Halbleiterschicht (16) aus III-V-Material umfassend, unbeabsichtigt dotiert, angeordnet auf der unteren Grenzschicht (14), eine obere Halbleiter-Grenzschicht (24) aus p-dotiertem III-V-Material, die aktive Zone bedeckend, wobei das verbotene Energieband der aktiven Schicht kleiner ist als das der Grenzschichten, eine erste Metallisierung (12), angeordnet über der oberen Grenzschicht, eine zweite Metallisierung (28), angeordnet auf dem Substrat, und eine Halbleiter-Diffusionssperrschicht (30) für die Dotierungsionen der oberen Grenzschicht, angeordnet zwischen der aktiven Schicht und der oberen Grenzschicht, wobei diese Vorrichtung
**dadurch gekennzeichnet** ist, daß die Sperrschicht (30) aus quarternärem III-V-Material erzeugt ist, dessen n-Typ-Dotierung höher ist als 10¹⁷ Ionen/cm³, und dadurch, daß die Sperrschicht (30) eine kleinere oder gleiche Dicke aufweist wie die aktive Schicht und außerdem Teil der aktiven Zone ist.

2. Vorrichtung nach Anspruch 1, dadurch gekennzeichnet, daß die quarternäre Schicht (30) dotiert ist mit einer Donatorenkonzentration, die gleich oder höher ist als die der Akzeptoren der oberen Grenzschicht.

3. Vorrichtung nach Anspruch 1 oder 2, dadurch gekennzeichnet, daß die quarternäre Schicht dotiert ist mit einer Konzentration aus Donatoren-Dotierionen von 5X10¹⁷ bis 5x10¹⁸ Ionen/cm³.

4. Vorrichtung nach einem der Ansprüche 1 bis 3, dadurch gekennzeichnet, daß die quarternäre Schicht (30) eine Zusammensetzung aufweist, die identisch ist mit einer der die aktive Schicht bildenden Schichten.

5. Vorrichtung nach einem der Ansprüche 1 bis 4, dadurch gekennzeichnet, daß die obere Grenzschicht (24) dotiert ist mit wenigstens 10¹⁸ Akzeptoren-Dotierionen/cm³.

6. Vorrichtung nach einem der Ansprüche 1 bis 5, dadurch gekennzeichnet, daß eine Schutzschicht (20) der aktiven Zone vorgesehen ist zwischen der oberen Grenzschicht und der ersten Metallisierung.

7. Vorrichtung nach einem der Ansprüche 1 bis 6, dadurch gekennzeichnet, daß das Substrat aus InP ist, die untere Grenzschicht (14) aus n-dotiertem InP ist, die aktive Schicht (16) aus Ga₁₋ₓInₓAs_{1-y}P_{y} mit 0≦x≦1 und 0≦y≦1 ist, unbeabsichtigt dotiert, die obere Grenzschicht (24) aus p⁺-dotiertem InP ist und die Diffusionssperrschicht (30) aus Ga₁_{-z}In_{z}As₁₋ₜPₜ mit 0≦z≦1 und 0≦t≦1 ist, n-dotiert mit einer Konzentration von 5x10¹⁷ bis 5x10¹⁸ Ionen/cm³.

8. Vorrichtung nach einem der Ansprüche 1 bis 7, dadurch gekennzeichnet, daß die aktive Zone (22) die Form eines Streifens aufweist, umgeben von der oberen Grenzschicht (24).

## Claims

1. Optoelectronic device having a III-V substrate (10), a lower, n-doped III-V material semiconductor confinement layer (14) in contact with the substrate (10), an active zone (22) having at least one not intentionally doped III-V material semiconductor layer (16) located on the lower confinement layer (14), an upper, p-doped III-V material semiconductor confinement layer (24) covering the active zone, the forbidden energy band of the active layer being below that of the confinement layers, a first metal coating (12) is placed on the upper confinement layer, a second metal coating (28) placed on the substrate and a semiconductor layer (30) for stopping the diffusion of doping ions from the upper confinement layer located between the active layer and the upper confinement layer, characterized in that the stopping layer is made from quaternary III-V material, whose type n doping exceeds 10¹⁷ ions/cm³ and in that said stopping layer (30) has a thickness equal to or lower than that of the active layer and also forms part of the active zone.

2. Device according to claim 1, characterized in that the quaternary layer (30) is doped at a donor ion concentration equal to or higher than that of the acceptor ions of the upper confinement layer.

3. Device according to claim 1 or 2, characterized in that the quaternary layer is doped with a doping donor ion concentration of 5X10¹⁷ to 5X10¹⁸ ions/cm³.

4. Device according to any one of the claims 1 to 3, characterized in that the quaternary layer (30) has a composition identical to one of the layers forming the active layer.

5. Device according to any one of the claims 1 to 4, characterized in that the upper confinement layer (24) is doped to at least 10¹⁸ doping acceptor ions/cm³.

6. Device according to any one of the claims 1 to 5, characterized in that a layer (20) protecting the active zone is provided between the upper confinement layer and the first metal coating.

7. Device according to any one of the claims 1 to 6, characterized in that the substrate is of InP, the lower confinement layer (14) of n-doped InP, the active layer (16) is of Ga₁₋ₓInₓAs_{1-y}P_{y}, with 0≦x≦1 and O≦y≦1, which is not intentionally doped, the upper confinement layer (24) is of p⁺-doped nP and the diffusion stopping layer (30) is of Ga₁₋_{z}In_{z}As₁₋ₜPₜ with 0<z<1 and 0<t<1, which is n-doped to a concentration of 5x10¹⁷ to 5x10¹⁸ ions/cm³.

8. Device according to any one of the claims 1 to 7, characterized in that the active zone (22) is in the form of a ribbon surrounded by the upper confinement layer (24).
